# EUROPEAN PATENT APPLICATION

(11) **EP 1 320 158 A1**
(43) Date of publication of application: **18.06.2003**
(21) Application number: 01310418.7
(22) Date of filing: 13.12.2001
(51) Int. Cl.: H01S 5/20

(54) **Means of controlling dopant diffusion in a semiconductor heterostructure**

(71) Applicant: Agilent Technologies, Inc. (a Delaware corporation), Palo Alto, CA 94303 (US)
(72) Inventor: Massa, John, Ipswich, Suffolk IP1 3JP (GB); Ryder, Paul, Ipswich, Suffolk IP1 3JP (GB); Berry, Graham, Bury St. Edmunds, Suffolk IP33 1JL (GB)
(74) Representative: Coker, David Graeme

(57) **Abstract**

A semiconductor structure comprising a p-i-n double heterostructure in which a high solubility layer is provided that reduces the diffusion of p-type dopants from a cladding layer into the active region. The high solubility layer is preferably formed between the p-type doped cladding layer and the active region.

## Description

This invention relates to the field of semiconductor devices and in particular to such devices that comprise a p-i-n double heterostructure.

Many optoelectronic semiconductor devices, such as lasers, LEDs, optical amplifiers and modulators, utilise p-i-n double heterostructures. A known disadvantage of such structures is that there is a tendency for the p-type dopants used in the second cladding layer to diffuse into the active later so that there is not a clearly defined distinction between the doped cladding layer and the active region, which is intended to be undoped. This contamination of the active region can lead to internal loss, due to intervalence band absorption, and reduced carrier mobility in the active region, due to impurity scattering, within lasers and amplifiers. In electro absorption modulators (EAMs) the presence of the dopant atoms in the active region can broaden the excitonic absorption effect and reduce the extinction ratio. The presence of high dopant concentrations in the active region can also shift the operating wavelength of the device due to bandgap shrinkage.

Known attempts to address this problem have not been entirely satisfactory. One proposed solution is to leave a thin undoped layer between the p-type doped cladding layer and the active region in an attempt to reduce the levels of dopant that diffuse into the active region. An alternative is to vary the dopant level within the cladding layer such that there is a very low dopant concentration at the boundary between the cladding layer and the active region, with the dopant concentration increasing with the distance from the active region. However, neither of these approaches have proved to be useful as a relatively high level of dopant diffuses into the active region, degrading the performance of the devices. Additionally, the addition of the undoped layer (or the layer with a low level of doping) can, for lasers and amplifiers, increase device resistance and reduce the height of the barrier over which electrons can escape from the intrinsic region. These effects can have a detrimental effect on the temperature range for which satisfactory device performance can be obtained. Furthermore, these techniques are process sensitive and thus not suited for volume production.

According to a first aspect of the invention there is provided a semiconductor structure comprising a substrate, a first doped cladding layer, an undoped active layer and a second doped cladding layer, the first doped cladding layer being formed on the substrate and the undoped active layer being formed between the first doped cladding layer and the second doped cladding layer characterised in that the semiconductor structure further comprises an absorbing layer that reduces the diffusion of dopant into the undoped active layer. The absorbing layer may be formed between the undoped active layer and one of the doped cladding layers Alternatively the absorbing layer may be formed within one of the doped cladding layers or, in a further alternative, the absorbing layer may be formed within the undoped active layer.

The substrate may comprise n-type dopants, with the first doped cladding layer comprising n-type dopants and the second doped cladding layer comprising p-type dopants. In this case the absorbing layer may be formed between the undoped active layer and the second doped cladding layer or within the second doped cladding layer.

Alternatively the substrate may comprise p-type dopants, with the first doped cladding layer comprising p-type dopants and the second doped cladding layer comprising n-type dopants. In this alternative case the absorbing layer may be formed between the undoped active layer and the first doped cladding layer or within the first doped cladding layer.

Preferably the absorbing layer comprises a III-V semiconductor material which further preferably comprises n-type dopants. The n-type dopant may be sulphur or silicon whilst the p-type dopant may be zinc or cadmium.

According to a second aspect of the invention there is provided method of forming a semiconductor structure, the method comprising the steps of (i) forming a substrate; (ii) forming a first doped cladding layer on the substrate; (iii) forming an undoped active layer and a second doped cladding layer such that the undoped active layer is between the first doped cladding layer and the second doped cladding layer, the method being
characterised by the additional step of (iv) forming an absorbing layer that reduces the diffusion of dopant into the undoped active layer.

The absorbing layer may formed between the undoped active layer and one of the doped cladding layers. In the alternative the absorbing layer is formed within one of the doped cladding layers, or the absorbing layer may be formed within the undoped active layer.

The invention will now be described, by way of example only, with reference to the following Figure in which:
Figure 1 shows a schematic depiction of a known semiconductor structure; and
Figure 2 shows a schematic depiction of a semiconductor structure according to the present invention.

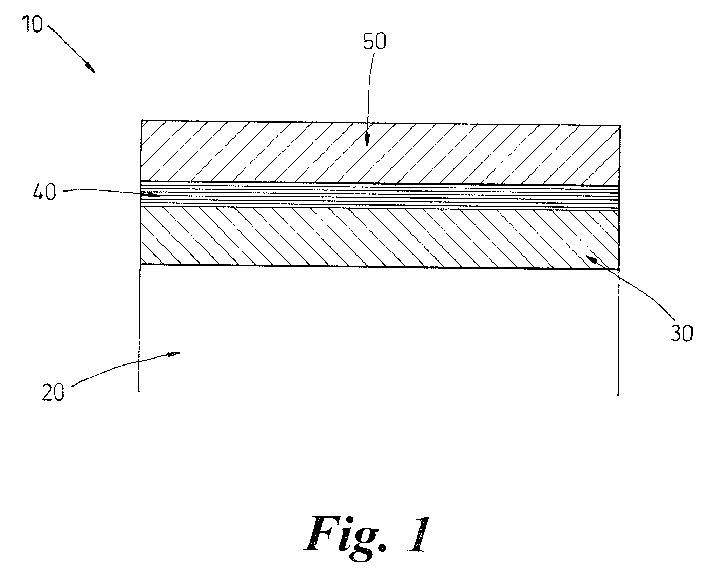

Figure 1 shows a schematic depiction of a known semiconductor structure 10 comprising a p-i-n double heterostructure. The structure comprises a substrate 20, on top of which is formed a first cladding layer 30 which is doped with n-type dopants. On top of this first cladding layer there is formed an undoped active region 40, on top of which is formed a second cladding layer 50 which is doped with a p-type dopant. In one example of such a semiconductor structure, the substrate is be n-type indium phosphide (InP), the first cladding layer is n-type InP, the active layer indium gallium arsenide (InGaAs) and the second cladding layer is p-type InP. Examples of n-type dopants are sulphur and silicon while examples of p-type dopants are zinc and cadmium. Such a structure is commonly used in lasers, optical amplifiers and EAMs.

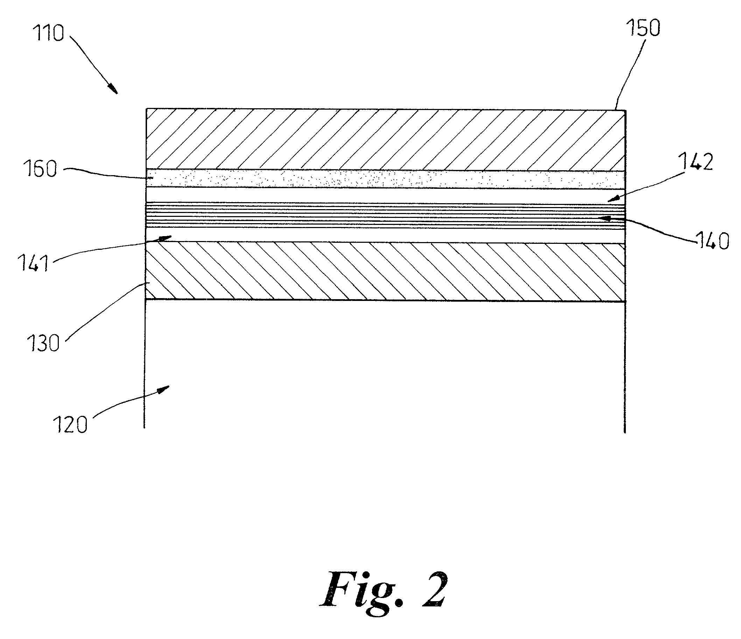

Figure 2 shows a semiconductor structure 110 according to the present invention. The semiconductor structure 110 is similar to the known structure described above, comprising substrate 120, first cladding layer 130, active region 140 and second cladding layer 150. The semiconductor structure 110 additionally comprises a barrier layer 160 which is formed between the active region 140 and the second cladding layer 150. The barrier layer 160 is such that the solubility of the p-type dopant used in the second cladding later is much greater in the barrier layer than in the second cladding layer. Thus, during the fabrication of the semiconductor structure the p-type dopants will diffuse into the barrier layer and remain there, preventing the dopants from reaching the active region. An example of a high solubility material that could be used for the barrier layer in III-V systems would be a material having a high group III vacancy concentration such as could be achieved using n-type doping or non-stoichiometric growth. If the p-type doped cladding layer is InP then an alloy containing at least one other group III atom would make a suitable material for the barrier layer.

An example of a semiconductor structure according to the present invention that is of application in forming an InGaAs/InP buried heterostructure semiconductor laser will now be described with reference to Figure 2. The substrate 120 is n-type InP (with a doping density of approximately 4 x 10¹⁸ cm⁻³). The lower cladding layer 130 is n-type InP, approximately 1.5µm thick and with a doping density of ≈2.5 x 10¹⁸ cm⁻³. The active region 140 comprises first and second confinement layers 141, 142 that comprise a layer of InGaAsP. The active region further comprises an undoped InGaAsP strained multiple quantum well (MQW) structure 145 that is formed between the first and second confinement layers. The barrier layer 160 comprises an n-type doped InP layer with a thickness of ≈15 nm and a doping density of ≈ 3 x 10¹⁸ cm⁻³ and this is capped with a second cladding layer of p-type doped InP with a thickness of ≈ 0.4µm and a doping density of ≈ 1.4 x 10¹⁸ cm⁻³.

The structure is fabricated using the standard processes for a buried heterostructure laser diode, including mesa etch and overgrowth. During the thermal cycling of the overgrowth process the p-type dopant from the second cladding layer will diffuse into the barrier layer with the high solubility for p-type dopants. This diffusion will change the electrical characteristics of the barrier layer from n-type to p-type, but the high solubility of the barrier layer greatly decreases the number of p-type dopants that are able to diffuse into the active layer. Devices created with the barrier layer have active region p-type dopant concentrations that are at least 5 times lower than for equivalent devices without the barrier layer. This decrease in dopant contamination is responsible for a significant reduction in the internal loss of the device.

It will be readily understood by those skilled in the art that the same result, namely the reduction of dopant contamination could be achieved by positioning the high solubility barrier layer in different positions within the structure and/or by changing the materials used to form the high solubility barrier layer. For example, the high solubility barrier layer could be made from n-type InGaAsP and be located in the upper part of the second confinement layer. This structure would still provide improved performance even if curing the processing the conductivity of the high solubility barrier layer was not converted completely to p-type. In this case a material with a wider bandgap such as n-doped InP or possibly n-doped GaAs or n-doped AlGaAs (although a GaAs or AlGaAs layer would need to be very thin since it would be highly strained if grown on InP) would be suitable. A further option would be to place the n-type doped InP high solubility barrier layer within the second cladding layer such that the high solubility barrier layer was near to, but not next to, the second confinement layer. In this case a narrower bandgap material could be used for the high solubility barrier layer, for example, n-doped InGaAs or n-doped InGaAsP. The n-type conductivity of the barrier layer can be achieved either by doping with an impurity or by nonstoichiometric growth.

Although the preceding discussion has focussed on semiconductor devices formed upon n-type substrates it will be immediately apparent to those skilled in the art that the present invention can also be implemented with devices that have a p-type substrate. In this case the first cladding layer would contain p-type dopants and the second cladding layer n-type dopants. Accordingly, the high solubility barrier layer would be located to reduce the flow of p-type dopants from the first cladding layer into the active layer. Thus the high solubility barrier layer could be located in between the first cladding layer and the active layer, within the lower part of the first confinement region or within the first cladding layer so as to be near, but not next to, the first confinement layer.

## Claims

1. A semiconductor structure (110) comprising a substrate (120), a first doped cladding layer (130), an undoped active layer (140) and a second doped cladding layer (150), the first doped cladding layer being formed on the substrate and the undoped active layer being formed between the first doped cladding layer and the second doped cladding layer
**characterised in that** the semiconductor structure further comprises an absorbing layer (160) that reduces the diffusion of dopant into the undoped active layer.

2. A semiconductor structure according to claim 1, wherein the absorbing layer (160) is formed between the undoped active layer (140) and one of the doped cladding layers (130, 150).

3. A semiconductor structure according to claim 1, wherein the absorbing layer (160) is formed within one of the doped cladding layers (130, 150).

4. A semiconductor structure according to claim 1, wherein the absorbing layer (160) is formed within the undoped active layer (140).

5. A semiconductor structure according to any preceding claim wherein the substrate (120) comprises n-type dopants, the first doped cladding layer (130) comprises n-type dopants and the second doped cladding layer (150) comprises p-type dopants.

6. A semiconductor 'structure according to claim 5 when dependent upon claim 2, wherein the absorbing layer (160) is formed between the undoped active layer (140) and the second doped cladding layer (150).

7. A semiconductor structure according to claim 5 when dependent upon claim 3, wherein the absorbing layer (140) is formed within the second doped cladding layer (150).

8. A semiconductor structure according to any of claims 1 to 4, wherein the substrate (120) comprises p-type dopants, the first doped cladding layer (130) comprises p-type dopants and the second doped cladding layer (150) comprises n-type dopants.

9. A semiconductor structure according to claim 8 when dependent upon claim 2, wherein the absorbing layer (160) is formed between the undoped active layer (140) and the first doped cladding layer (130).

10. A semiconductor structure according to claim 8 when dependent upon claim 3, wherein the absorbing layer (160) is formed within the first doped cladding layer (130).

11. A semiconductor structure according to any preceding claim, wherein the absorbing layer (160) comprises a III-V semiconductor material.

12. A semiconductor structure according to claim 12, wherein the III-V semiconductor material comprises n-type dopants.

13. A semiconductor structure according to any preceding claim, wherein the n-type dopant may be sulphur or silicon.

14. A semiconductor structure according to any preceding claim, wherein the p-type dopant may be zinc or cadmium.

15. A method of forming a semiconductor structure (110), the method comprising the steps of
(i) forming a substrate (120);
(ii) forming a first doped cladding layer (130) on the substrate;
(iii)forming an undoped active layer (140) and a second doped cladding layer (150) such that the undoped active layer (140) is between the first doped cladding layer (130) and the second doped cladding layer (150), the method being **characterised by** the additional step of
(iv) forming an absorbing layer (160) that reduces the diffusion of dopant into the undoped active layer.

16. A method of forming a semiconductor structure according to claim 15, wherein the absorbing layer (160) is formed between the undoped active layer (160) and one of the doped cladding layers (130, 150).

17. A method of forming a semiconductor structure according to claim 15, wherein the absorbing layer (160) is formed within one of the doped cladding layers (130, 150).

18. A method of forming a semiconductor structure according to claim 15, wherein the absorbing layer (160) is formed within the undoped active layer (140).
